(19) Europäisches Patentamt

European Patent Office

Office européen des brevets

(11) **EP 0 631 385 B1**

(12) **FASCICULE DE BREVET EUROPEEN**

(45) Date de publication et mention de la délivrance du brevet:
**02.09.1998 Bulletin 1998/36**

(51) Int Cl.⁶: **H03H 7/38**

(21) Numéro de dépôt: **94401379.6**

(22) Date de dépôt: **20.06.1994**

(54) **Dispositif pour limiter la désadaptation d'impédance d'une liaison point à multipoints comportant des lignes bus imprimées sur un substrat isolant rigide**

Vorrichtung zum Begrenzen der Impendanzfehlanpassung einer Punkt zu Mehrpunktverbindung mit gedrückten Busleitungen auf einem starren isolierenden Substrat

Device for limiting the impedance mismatch of a point to multipoint connection comprising buslines printed on a rigid isolating substrate

(84) Etats contractants désignés:
**AT BE CH DE ES FR GB IT LI NL SE**

(30) Priorité: **21.06.1993 FR 9307470**

(43) Date de publication de la demande:
**28.12.1994 Bulletin 1994/52**

(73) Titulaire: **ALCATEL ALSTHOM COMPAGNIE GENERALE D'ELECTRICITE**
**75008 Paris (FR)**

(72) Inventeurs:
• **Lassaux, Jean**
**F-22300 Lannion (FR)**

• **Geffroy, Pascal**
**F-22300 Lannion (FR)**

(74) Mandataire: **Sciaux, Edmond et al**
**COMPAGNIE FINANCIERE ALCATEL**
**Dépt. Propr. Industrielle,**
**30, avenue Kléber**
**75116 Paris (FR)**

(56) Documents cités:
**FR-A- 2 613 539**

# Description

L'invention concerne un dispositif pour limiter la désadaptation d'impédance d'une liaison point à multipoints comportant des lignes bus imprimées sur un substrat isolant rigide. Elle s'applique notamment à un fond de panier tel qu'on en trouve dans les bacs d'équipements électroniques, pour relier des cartes d'électroniques.

Les cartes sont enfichées, à leur extrémité, dans 1 ou plusieurs connecteurs dont les points de contact sont soudés sur un circuit imprimé constituant le fond de panier. Un fond de panier comporte généralement des lignes bus reliant l'ensemble des cartes du fond de panier, et ayant classiquement la forme de droites parallèles.

Dans les équipements électroniques actuels, les échanges d'informations sous la forme de signaux logiques ont des débits de plus en plus élevés. Dans le cas où l'impédance caractéristique de la liaison n'est pas constante sur l'ensemble de la longueur (notamment lorsque des cartes sont absentes à certains endroits), des réflexions peuvent se produire à chaque point de désadaptation et altérer dangereusement la qualité des signaux transmis : Si la déformation des signaux est importante, elle peut conduire à un mauvais fonctionnement des circuits logiques reliés aux lignes bus. Il est donc nécessaire de soigner l'impédance caractéristique de la liaison sur l'ensemble de sa longueur. Mais il est difficile de maintenir constante l'impédance caractéristique de la liaison dans le cas où le panier comporte un nombre variable de cartes. En effet, si l'adaptation d'impédance est bien réalisée lorsque le panier est rempli du nombre maximal de cartes, elle est forcément moins bien réalisée lorsqu'un certain nombre de cartes sont absentes.

Pour remédier à ce problème, il est connu d'utiliser des cartes dites de remplissage, qui sont des cartes ayant comme seule fonction de simuler la présence des cartes manquantes, en présentant une impédance analogue à celle présentée par la carte manquante. L'équipement électronique est donc plus coûteux, à cause de la nécessité de prévoir des cartes de remplissage; et la mise en oeuvre de cet équipement est plus compliquée puisqu'il y a une contrainte consistant à mettre en place une carte de remplissage à chaque emplacement de carte qui est inoccupé. Le but de l'invention est d'éliminer les inconvénients de cette solution connue.

Le document FR 2,613,539 décrit un connecteur de bus à impédance adaptée, réalisé sur un circuit imprimé souple qui permet de relier deux cartes électroniques.

L'objet de l'invention est un dispositif pour limiter la désadaptation d'impédance d'une liaison point à multipoints comportant des lignes bus imprimées sur un substrat isolant rigide, et une pluralité de connecteurs constitués de points de contact pour des cartes électroniques, lorsque certaines cartes sont absentes de ces connecteurs; caractérisé en ce que la longueur de chaque portion de ligne bus entre deux points de contact successifs est supérieure à la largeur de l'intervalle entre ces deux points de contact.

Le dispositif ainsi caractérisé permet d'éviter l'utilisation de cartes de remplissage, car il réduit la désadaptation d'impédance causée par l'absence d'une ou de plusieurs cartes. En effet, le fait de rallonger chaque portion de ligne bus reliant deux emplacements successifs, réduit l'influence de la présence ou de l'absence d'une carte sur un emplacement donné.

Selon un mode de réalisation préférentiel, chaque ligne bus a la forme d'une suite de créneaux. Ce mode de réalisation a pour avantage d'être facile à réaliser, car la forme en créneaux permet de loger une portion de ligne ayant une longueur très supérieure à la largeur de l'intervalle entre deux points de contact successifs, et permet d'imbriquer les créneaux de plusieurs lignes parallèles.

L'invention sera mieux comprise et d'autres détails apparaîtront à l'aide de la description ci-dessous et des figures l'accompagnant :

- la figure 1 représente schématiquement un premier exemple de liaison point à multipoints ayant comme support un fond de panier, sans le dispositif selon l'invention;
- la figure 2 représente le schéma électrique équivalent à ce premier exemple de liaison lorsque le fond de panier est équipé de l'ensemble de ses cartes électroniques, sans le dispositif selon l'invention;

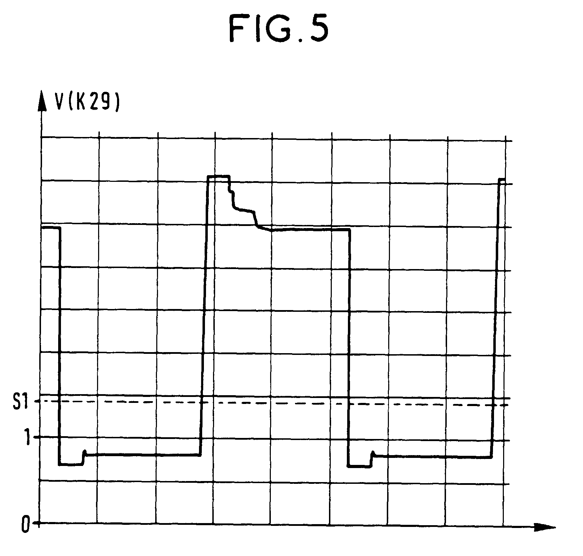

- les figures 3, 4, 5 représentent trois oscillogrammes illustrant le fonctionnement de ce premier exemple de liaison, sans le dispositif selon l'invention;
- la figure 6 représente le schéma électrique équivalent à ce premier exemple de liaison lorsque le fond de panier est équipé seulement de la moitié de ses cartes électroniques, sans le dispositif selon l'invention;
- les figures 7, 8, 9 représentent trois oscillogrammes illustrant le fonctionnement de ce premier exemple de liaison quand le fond de panier est équipé seulement de la moitié de ses cartes, sans le dispositif selon l'invention,
- la figure 10 représente un exemple de ligne bus ayant une forme en créneaux;
- la figure 11 représente le schéma électrique équivalent à ce premier exemple de liaison, lorsque le fond de panier est équipé seulement de la moitié de ses cartes électroniques, mais avec le dispositif selon l'invention,
- les figures 12, 13, 14 représentent trois oscillogrammes illustrant le fonctionnement de ce premier exemple liaison, lorsque le fond de panier est équipé seulement de la moitié de ses cartes électroniques, mais avec le dispositif selon l'invention;
- la figure 15 représente le schéma électrique équivalent à un second exemple de liaison point à multipoints, ayant comme support un fond de panier et un câble coaxial raccordé à ce fond de panier;

- la figure 16 représente un oscillogramme illustrant le fonctionnement de ce second exemple de liaison, lorsque le fond de panier est équipé seulement de la moitié de ses cartes électroniques, sans le dispositif selon l'invention;

- la figure 17 représente un oscillogramme illustrant le fonctionnement de ce second exemple de liaison, lorsque le fond de panier est équipé seulement de la moitié de ses cartes électroniques, mais avec le dispositif selon l'invention.

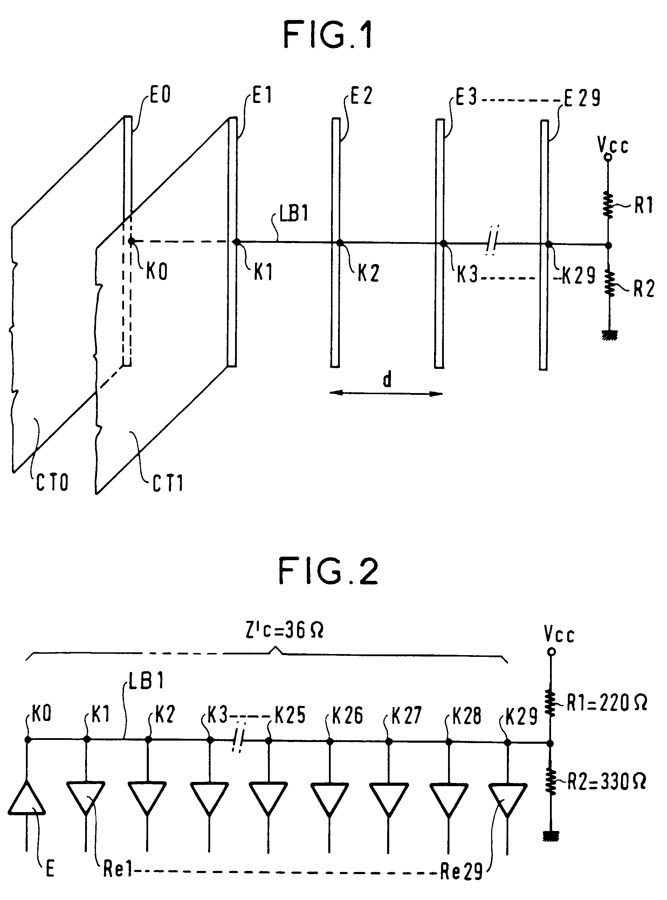

Le fond de panier représenté sur la figure 1 est prévu pour contenir 30 cartes, par exemple, et comporte donc 30 emplacements EO, E1, E2, E3, ..., E29 qui sont munis chacun d'un connecteur pour recevoir des cartes électroniques CTO, CT1, .... Ces connecteurs sont interconnectés par une pluralité de ligne bus, droites, parallèles entre elles, et perpendidulaires au grand axe des connecteurs. Pour simplifier la figure, une seul ligne bus LB est représentée. Cette ligne assure une liaison point à multipoints entre des points de contact KO, K1, K2, K3, ..., K29, qui sont homologues sur les connecteurs équipant les emplacements EO, ..., E29.

Dans cet exemple, comme c'est souvent le cas, les emplacements sont équidistants et sont séparés d'une distance d. Une extrémité de chaque ligne bus est reliée à un potentiel de référence par une résistance R2, et à un potentiel Vcc, d'une source de tension continue, par une résistance R1.

Lorsque toutes les cartes sont absentes, l'impédance caractéristique du fond de panier a une valeur plus importante (par exemple : 75 Ω) que lorsque tous les emplacements sont équipés de cartes (par exemple : 36 Ω).

Pour éviter que l'absence de certaines cartes provoque une modification de l'impédance caractéristique de la liaison, la solution classique consiste à insérer, dans les emplacements inoccupés, des cartes de remplissage présentant une capacité d'entrée semblable à celle des cartes réelles.

La figure 2 représente le schéma électrique équivalent à cet exemple de fond de panier lorsqu'il est entièrement équipé de cartes. Un émetteur E situé sur une carte émet un signal sur la ligne bus LB au point de contact KO. Les points de contact K1, ..., K29 sont respectivement reliés à des récepteurs à hystérésis, Re1, ..., Re29, situés sur des cartes. L'émetteur E et les récepteurs Re1, ..., Re29 sont réalisés en technologie dite TTL (Transistor Transistor Logic).

Les résistances R1 et R2 ont respectivement pour valeur 220 Ω et 330 Ω. Ces valeurs sont choisies en fonction des caractéristiques de l'émetteur E. Elles correspondent à une charge de 132 Ω, et non de 36 Ω, mais il n'est pas possible de réduire les valeurs de R1 et R2, à cause de l'insuffisance de la puissance fournie par l'émetteur réalisé en technologie TTL.

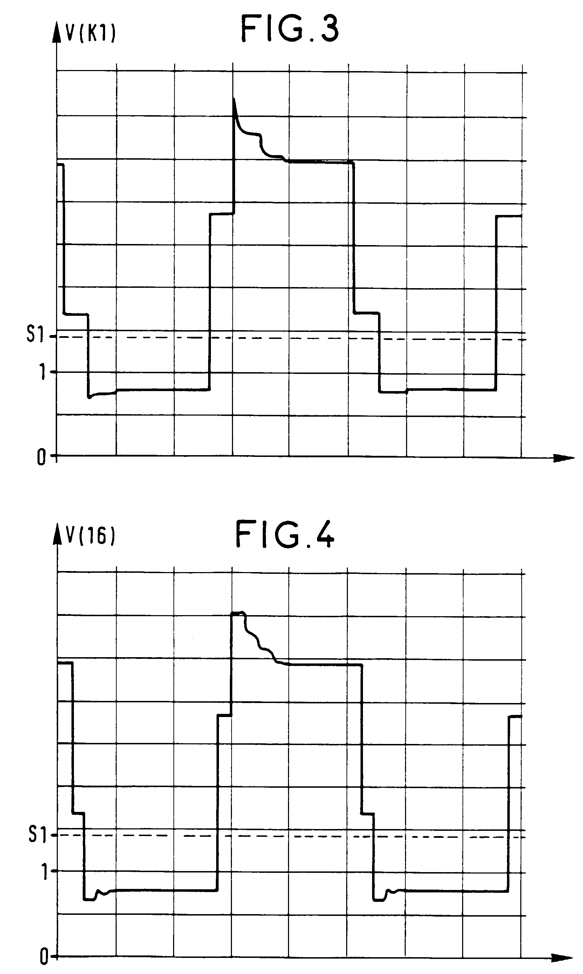

La figure 3 représente trois oscillogrammes V(K1), V(K16), V(K29) représentant respectivement les tensions sur les points de contact KO, K16, K29 lorsque le fond de panier est entièrement équipé de cartes. L'émetteur E fournit, dans cet exemple, une tension impulsionnelle dite carrée, c'est-à-dire de rapport cyclique $\frac{1}{2}$, et ayant une période de 250 nS. La tension S1 représentée en pointillés est le seuil inférieur de commutation des récepteurs à hystérésis Re1, ..., Re29.

La tension V(K1) est celle reçue par le récepteur Re1 situé sur une carte située à une première extrémité de la ligne bus LB, près de l'émetteur E. La tension V(K16) est celle reçue par le récepteur Re16 situé sur une carte située à peu près au milieu de la ligne bus LB. La tension V(K29) est celle reçue par le récepteur Re29 situé sur une carte située à l'autre extrémité de la ligne bus LB. Les oscillogrammes des tension V(K16) et V(K29) sont décalés dans le temps par rapport à l'oscillogramme de la tension V(K1), à cause de la distance séparant les cartes, et parce que la vitesse de propagation des signaux n'est pas infinie. Ces trois oscillogrammes montrent que les tensions reçues tout le long de la ligne bus LB sont peu déformées lorsque le fond de panier est rempli de cartes. La bonne conservation des signaux est dûe au fait que l'impédance caractéristique apparente, Z'c = 36Ω dans cet exemple, est homogène sur l'ensemble de la longueur de la liaison.

Par contre, si on enlève des cartes, les signaux sont dégradés car des réflexions apparaissent sur les points de connexions où il n'y a plus de carte.

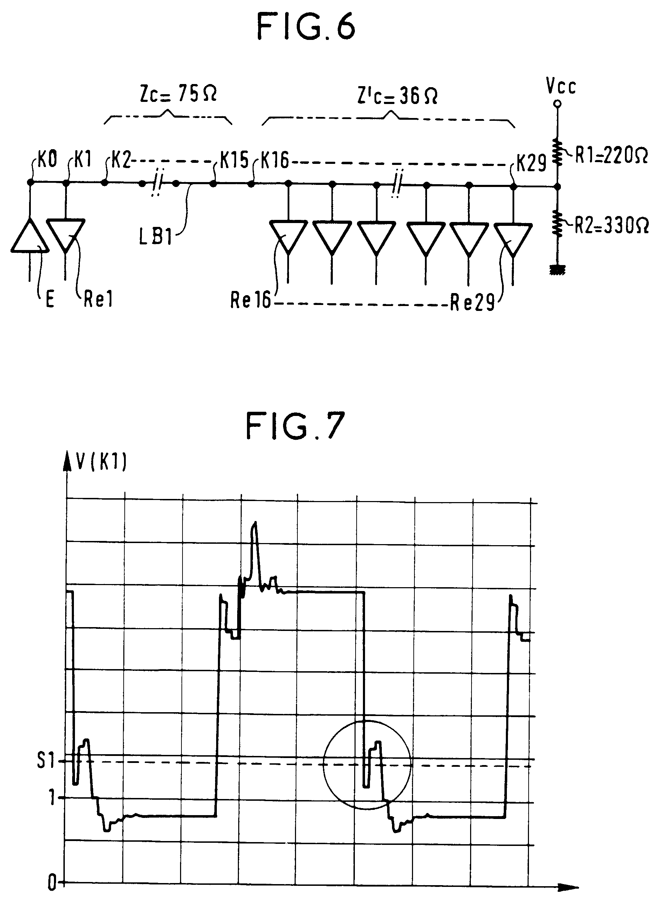

La figure 6 représente le schéma électrique équivalent à ce fond de panier dans un cas où il n'est que équipé de la moitié de ses cartes. L'émetteur E émet encore un signal carré au point de contact KO. Les points de contact K1, K16, ..., K29 sont reliés respectivement à des récepteurs Re1, R16, Re29 situés sur de cartes; et les points de contact K2, ..., K15 ne sont connectés à aucune carte.

Sur le tronçon, de la ligne LB, reliant les points de contact K16, ..., K29, l'impédance caractéristique apparente est Z'c= 36 Ω dans cet exemple. Sur le tronçon reliant les points de contact K2, ..., K15, l'impédance caractéristique est Zc=75Ω.

On démontre que l'impédance caractéristique apparente Z'c d'un tronçon de ligne muni de cartes à intervalles réguliers, tel que celui reliant les points de contact K16, ..., K29 est donnée approximativement par la formule :

$$Z'c = Zc \left[ \cfrac{1}{1 + \cfrac{C}{Co \times L}} \right]^{\frac{1}{2}}$$

où :

L est la longueur en centimètres de la ligne entre deux points de contact consécutifs, dans l'hypothèse où les points de contact KO, ..., K29 sont équidistants (L= d dans le cas d'une ligne droite);

C est la capacité d'entrée de chaque carte, en picofarads;

Co est la capacité intrinsèque du tronçon de ligne, en l'absence de cartes, en picofarads par centimètres;

Zc est l'impédance caractéristique du tronçon de ligne lorsqu'il ne comporte aucune carte (Elle dépend notamment de la largeur de la piste et de la permittivité du substrat isolant).

Cette formule montre que l'impédance caractéristique apparente Z'c d'un tronçon de ligne bus complètement équipé de cartes n'est pas fonction de la longueur du tronçon de ligne et du nombre total de cartes présentes sur ce tronçon de ligne bus, mais dépend de la longueur L de la ligne bus entre deux cartes consécutives. Cette formule n' est applicable que si le temps d'un aller-retour entre deux cartes est inférieur au temps de montée du signal. Sinon, le tronçon de ligne entre deux cartes consécutives est vu comme une ligne de transmission ayant une impédance caractéristique Zc et une certaine charge terminale.

Les figures 7, 8, 9 représentent respectivement les oscillogrammes des tensions V(K1), V(K16), et V(K29) relevées respectivement sur les points de contact K1, K16, K29, quand le fond de panier est seulement à moitié rempli de cartes. Ce sont donc les tensions reçues respectivement par les récepteurs Re1, Re16, et Re29.

L'oscillogramme de la tension V(K1) est dangereusement déformé à cause des signaux réfléchis au niveau de la rupture de l'impédance caractéristique, au voisinage des points de contact K15 et K16

Sur la figure 7 (partie encerclée), la déformation du flanc descendant comporte une vallée franchissant le seuil de commutation S1 du récepteur à hytérésis, Re1, et peut conduire à une interprétation erronée des signaux binaires par le récepteur Re1 (bien qu'il présente une hystérésis), si le pic suivant cette vallée a une amplitude dépassant la tension de seuil haut (non représentée) du récepteur à hystérésis. Dans ces conditions, il est préférable d'utiliser des cartes de remplissage à l'emplacement des cartes manquantes, pour éviter des discontinuités de l'impédance caractéristique de la liaison, au niveau des emplacements des cartes absentes.

Naturellement, les fronts montants du signal présentent des déformations analogues qui peuvent provoquer la détection de deux transitions pour un même front montant.

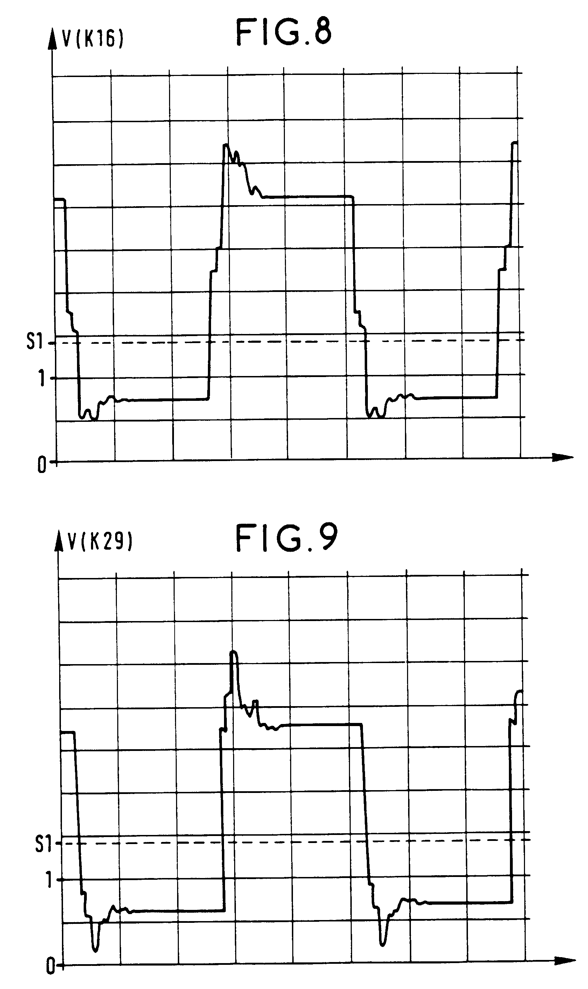

Les oscillogrammes des tensions V(K16) et K(K29) sur les figures 8 et 9, par contre, présentent peu de déformation.

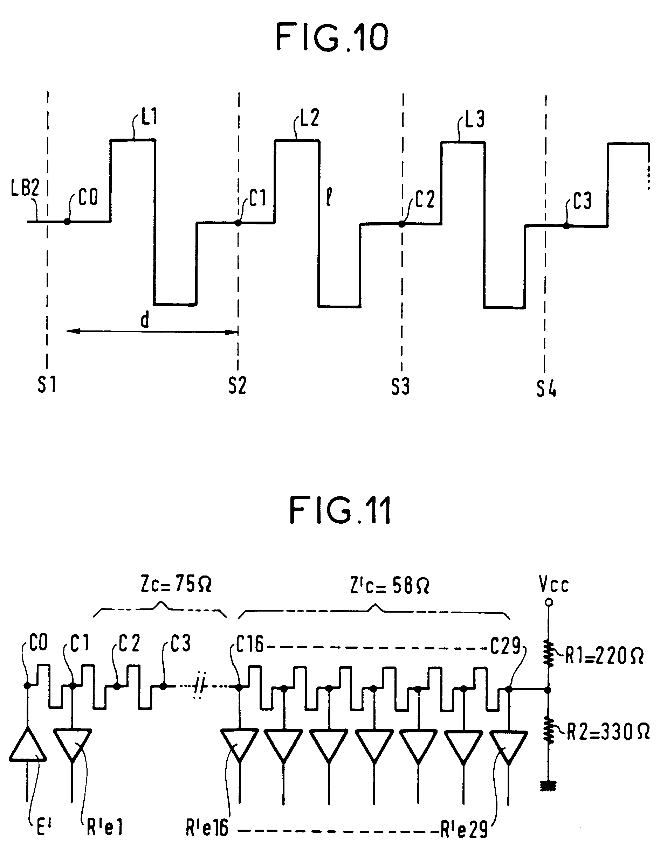

La figure 10 représente un exemple de réalisation du dispositif selon l'invention, et plus particulièrement d'une ligne bus LB2 reliant 4 points de contact CO, ..., C3 appartenant à des connecteurs situés à des emplacements S1, S2, S3, S4 séparés d'un pas de longueur d inférieure à la longueur L de la piste entre 2 connecteurs. Chaque portion L1, L2, L3 de la ligne entre deux points de contact consécutifs n'a pas la forme d'un segment de droite mais a, par exemple, une forme en créneaux comportant deux créneaux symétriques par rapport au centre de symétrie de ces deux points de contact consécutifs.

La ligne bus LB2 est imprimée par un procédé classique sur une première face d'un substrat plan, isolant et rigide. La liaison de masse pour le retour de chaque ligne bus LB2 est réalisée par un plan de masse imprimé sur la seconde face du substrat isolant rigide, et non représenté. Selon une variante de réalisation le plan de masse peut-être remplacé par des lignes ayant la même forme que les lignes bus, et placées en vis-à-vis.

Dans d'autres exemples de réalisation, les portions L1, L2, L3 de la liaison peuvent avoir des formes différentes d'un créneau, l'important étant de choisir convenablement la longueur L de l'équipotentielle entre 2 points de contact consécutifs.

La longueur L peut être déterminée en appliquant la formule (2) suivante qui est déduite de la formule (1), en se fixant une valeur $\frac{Zc}{Z'c}$ acceptable, c'est-à-dire qui ne provoque pas une déformation de signal telle que les récepteurs risquent de détecter une fausse transition de niveau logique.

$$(2) \qquad L = \frac{C}{Co} \times \frac{1}{\left[\dfrac{Zc}{Z'c}\right]^2 - 1}$$

Dans un exemple de réalisation, il a été constaté expérimentalement qu'un rapport $\frac{Zc}{Z'c} = 1{,}3$ est acceptable. Cette valeur varie évidemment pour chaque application et l'Homme de l'Art est capable de la déterminer par quelques essais.

Par ailleurs, la valeur de l'impédance caractéristique, Zc=75 Ω, d'un tronçon de ligne non équipée de cartes, et la valeur de la capacité intrinsèque C = 1pF/cm sont pratiquement imposées par des considérations technologiques lors de la réalisation du circuit imprimé constituant le fond de panier. La valeur de Z'c correspondant à $\frac{Zc}{Z'c}=1{,}3$ est donc de 58 Ω.

On en déduit la longueur L de chaque portion de ligne L1, L2, L3, entre deux points de contact consécutifs, en appliquant la formule (2) avec les valeurs paramètres :

$$\left[\begin{array}{l} Z'c = 58\Omega \\ Zc = 75\Omega \\ C = 10pF \\ Co = 1pF \end{array}\right.$$

La longueur L obtenue par cette formule (2) est 15 centimètres.

Il apparaît que si le pas imposé est d=3cm, il est assez facile de réaliser des créneaux permettant d'obtenir un tronçon de ligne ayant une longueur de 15 centimètres dans l'intervalle situé entre deux emplacements de carte consécutifs.

La figure 11 représente le schéma électrique équivalent à un fond de panier, équipé de l'exemple de réalisation représenté sur la figure 10, lorsque les 30 emplacements ne comportent que 15 cartes.

Un émetteur E' émet un signal carré au point de contact CO, qui est situé à une première extrémité d'une ligne bus LB'. Les points de contact C2, C3, ..., C15 ne sont connectés à aucune carte. La portion de la ligne LB' correspondant à ces points présente une impédance caractéristique Zc égale à 75Ω. Les points de contact C1, C16, ..., C29 connectent 15 cartes portant respectivement des récepteurs R'e1, R'e16, ..., R'e29. Ce tronçon de la ligne LB' présente une impédance caractéristique apparente de 58 Ω, au lieu de 36 Ω, grâce au dispositif selon l'invention.

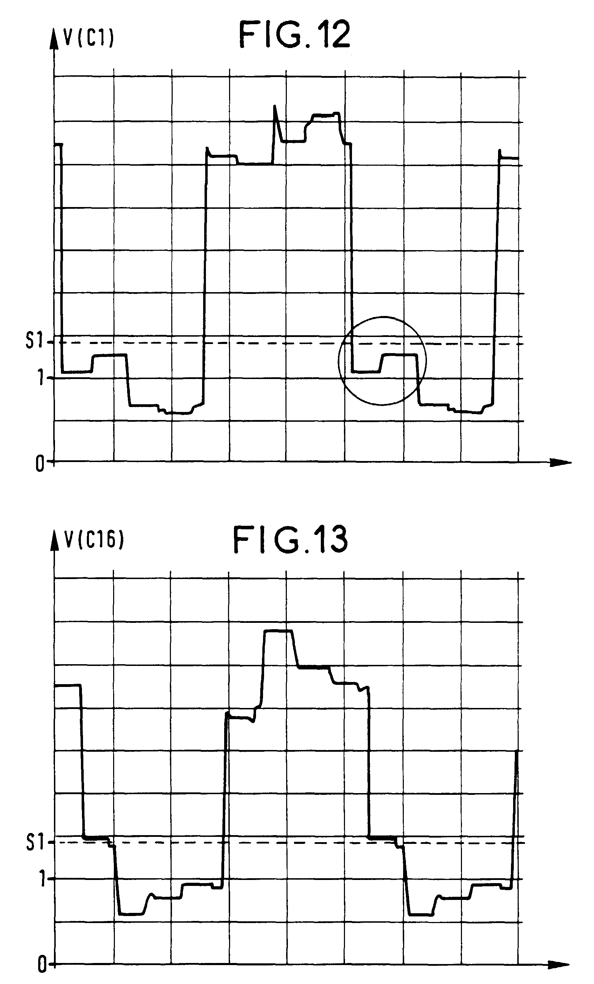

Les figures 12, 13, 14 représentent trois oscillogrammes des tensions V(C1), V(C16), V(C29), relevées respectivement à la sortie du circuit émetteur E', à l'entrée du récepteur R'e16 et à l'entrée du récepteur R'e29. L'oscillogramme de la tension V(C1) est moins déformé que celui de la tension V(K1) sur la figure 7. La vallée et le pic de cette déformation ne franchissent pas la tension de seuil S1 (partie encerclée). Le récepteur à hystérésis R'e1 ne peut détecter deux transitions sur le même front descendant.

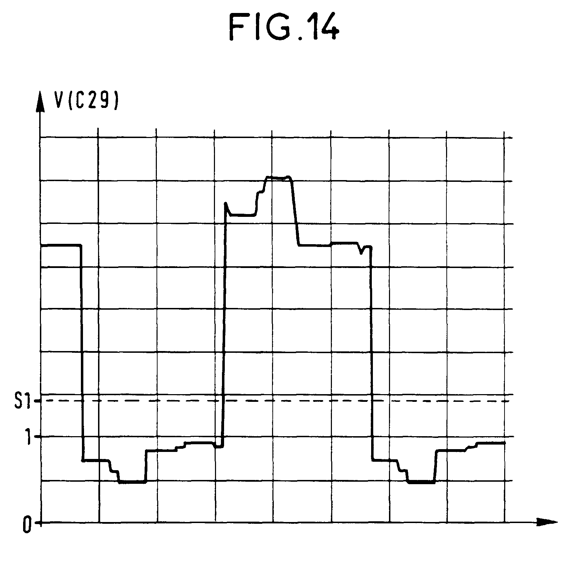

Les oscillogrammes des tensions V(C16) et V(C29) sur les figures 13 et 14, sont peu déformés. Il n'y a pas de risque de détecter deux transitions pour un même front de montée ou de descente.

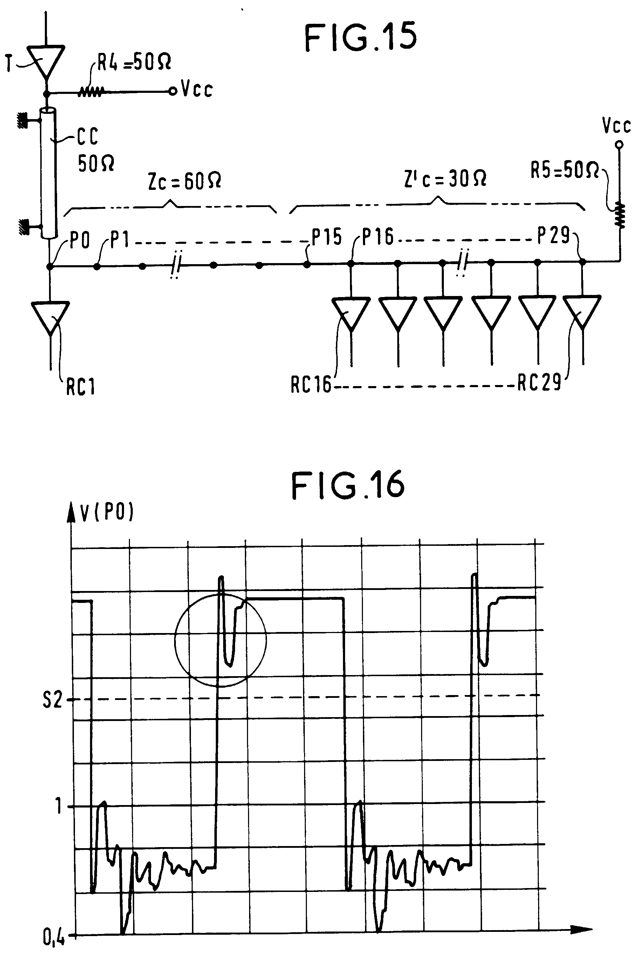

La figure 15 représente un second exemple de liaison 15 point à multipoints, ne comportant de dispositif selon l'invention. Cette liaison a comme support un câble coaxial CC et une ligne bus LB3 d'un fond de panier comportant 30 points de contact PO, ..., P29. Le fond de panier est à moitié chargé (cas le plus défavorable pour l'allure des signaux).

Le câble coaxial CC relie la sortie d'un émetteur T, situé hors du panier, au point P1 du fond de panier. Une résistance R4 = 50Ω relie la sortie de l'émetteur T à une source de tension Vcc et définit une impédance de sortie égale à 50Ω pour cet émetteur. Le câble CC a une impédance caractéristique égale à 50 Ω, et un temps de propagation égal à 12ns, et fournit des signaux carrés ayant une période de 250 nS.

Une carte portant un récepteur RCO est connectée au point PO. Des cartes portant respectivement des récepteurs RC16, ..., RC29 sont connectées respectivement aux points P16, ..., P29. L'extrémité de la ligne bus LB3, du côté du récepteur RC29, est chargée par une résistance R5 ayant une valeur de 50 Ω et qui est reliée à une source de tension Vcc. L'émetteur T et les récepteurs RC16, ..., RC29 sont réalisés en technologie dite BTL (Backplane Transceiver Logic) qui est conçue pour supporter une charge de 50 Ω.

La ligne bus LB3 est une ligne droite classique. La distance d entre deux connecteurs consécutifs est égale à 3 cm. Les caractéristiques des pistes et de l'isolant sont différentes de celles du premier exemple de liaison. L'impédance caractéristique est Zc= 60 Ω sur un tronçon de ligne entièrement équipé de cartes.

La figure 16 représente l'oscillogramme de la tension V(PO) relevée au point PO dans ce second exemple de liaison, sans le dispositif selon l'invention. Cette tension présente une déformation (encerclée sur la figure) qui est dangereusement proche du seuil S2 de commutation du récepteur RC1. En effet, il y a une désadaptation entre le tronçon de ligne PO, ..., P15 où l'impédance caractéristique est Zc= 60 n, et le tronçon P16, ..., P29 où il y a une impédance caractéristique apparente zZzZ'c=30Ω.

L'application de la formule (2) indique qu'il est possible d'améliorer la forme de cette tension en réalisant une ligne bus en forme de créneaux, analogue à celle décrite en se référant à la figure 10, avec une longueur de ligne, L = 8 cm, entre deux points de contact consécutifs, si on tolère un rapport de désadaptation $\frac{Zc}{Z'c}$= 1,5, pour C= 10 pF et Zc= 60Ω.

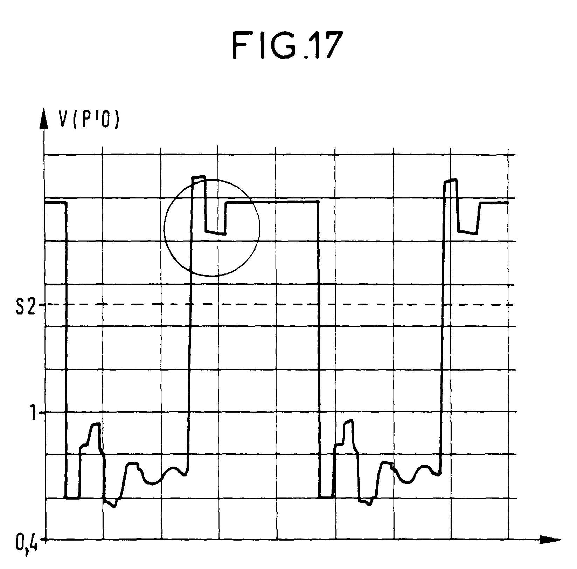

La figure 17 représente l'oscillogramme de la tension V(P'O) relevée au point P'O, correspondant au point PO, quand on modifie ce deuxième exemple de liaison pour lui intégrer le dispositif selon l'invention, avec une longueur L=8cm. Il apparaît que la déformation (partie encerclée) est plus faible et qu'il n'y a plus de risque qu'elle franchisse le seuil S2.

La piste de circuit imprimé constituant une ligne bus peut être réalisée selon la technique dite microstrip ou selon la technique dite stripline. Selon la technique microstrip, une piste conductrice est supportée par une plaque isolante dont l'autre face est recouverte d'un plan de masse. Selon la technique stripline, une piste conductrice est enterrée dans une couche de matériau isolant dont les deux faces sont recouvertes chacune d'un plan de masse.

Pour une technique donnée, un matériau isolant donné, et une épaisseur donnée de cet isolant, un abaque classique permet de déterminer la largeur de la piste en fonction de l'impédance Zc choisie; ou bien de déterminer l'impédance Zc en fonction de la largeur de la piste choisie pour des raisons technologiques. Un autre abaque permet de déterminer la capacité intrinsèque Co de la piste en fonction de la largeur de cette piste. Il est donc possible de fixer Z'c ou bien la largeur de la piste, et de fixer Zc; puis d'en déduire la valeur de C; puis d'en déduire la valeur de la longueur L, connaissant la capacité d'entrée Co d'une carte, grâce à la formule (2).

La portée de l'invention n'est pas limitée aux deux exemples de liaison décrits ci-dessus. Il est à la portée de L'homme de l'Art de réaliser des pistes ayant une forme différente des créneaux représentés sur la figure 10, pour obtenir une longueur L calculée selon la formule (2). Par exemple, chaque portion L1, L2, L3 peut être constituée de plusieurs segments de droite formant un premier angle aigu dont la pointe est dirigée vers le haut de la figure, et un second angle aigu dont la pointe est dirigée vers le bas de la figure.

## Revendications

1. Dispositif pour limiter la désadaptation d'impédance d'une liaison point à multipoints comportant des lignes bus (LB') imprimées sur un substrat isolant rigide et une pluralité de connecteurs (S1, ..., S4) constitués de points de contact (C1, ..., C4) pour des cartes électroniques, lorsque certaines cartes sont absentes de ces connecteurs;

    caractérisé en ce que la longueur de chaque portion (L1, ..., L3) de ligne bus (LB') entre deux points de contact successifs (C1, C2) est supérieure à la largeur (d) de l'intervalle entre ces deux points de contact.

2. Dispositif selon la revendication 1, caractérisé en ce que chaque ligne bus (LB') a la forme d'une suite de créneaux (L1, L2, L3).

## Patentansprüche

1. Vorrichtung zum Begrenzen der Impedanzfehlanpassung einer Punkt-zu-Mehrpunktverbindung mit auf ein starres isolierendes Substrat gedruckten Busleitungen (LB') und einer Mehrzahl von durch Kontaktpunkte (C1, ..., C4) für Elektronikkarten gebildeten Verbindern (S1, ..., S4), wenn bestimmte Karten an diesen Verbindern fehlen; dadurch gekennzeichnet, daß die Länge jedes Abschnittes (L1, ..., L3) der Busleitung (LB') zwischen zwei aufeinanderfolgenden Kontaktpunkten (C1, C2) größer ist als die Breite (d) des Zwischenraumes zwischen diesen zwei Kontaktpunkten.

2. Vorrichtung nach Anspruch 1, dadurch gekennzeichnet, daß jede Busleitung (LB') die Form einer Folge von Zinnen (L1, L2, L3) hat.

## Claims

1. A device for limiting the impedance mismatch of a point-to-multipoint link comprising bus lines (LB') printed on a rigid insulative substrate and a plurality of electronic circuit board connectors (S1, ..., S4) consisting of pins (C1, ..., C4) when some boards are absent from the connectors;

    characterised in that the length of each portion (L1, ..., L3) of bus line (LB') between two successive pins (C1, C2) is greater than the width (d) of the space between the two pins.

2. A device according to claim 1 characterised in that each bus line (LB') is in the form of a series of crenellations (L1, L2, L3).

# FIG.1

# FIG.2

# FIG.3

V(K1)

S1

1

0

# FIG.4

V(16)

S1

1

0

# FIG.5

# FIG.6

# FIG.7

# FIG.8

# FIG.9

# FIG.10

# FIG.11

# FIG.12

# FIG.13

# FIG.14

# FIG.15

# FIG.16

# FIG.17